# EUROPEAN PATENT SPECIFICATION

(11) **EP 1 276 232 B1**
(45) Date of publication and mention of the grant of the patent: **14.05.2008**
(21) Application number: 01306052.0
(22) Date of filing: 13.07.2001
(51) Int. Cl.: H03G 3/30

(54) **Transmitter power amplifier control**
Sender Leistungsverstärkersteuerung
Contrôle d' amplificateur de puissance d'un émetteur

(43) Date of publication of application: 15.01.2003
(73) Proprietor: TTPCOM Limited, Royston, Hertfordshire, SG8 6EE (GB)
(72) Inventor: Wurm, Patrick, c/o TTPCOM Limited, Royston, Hertfordshire SG8 6EE (GB); Henshaw, Robert, c/o TTPCOM Limited, Royston, Hertfordshire SG8 6EE (GB); Freeborough, David, c/o TTPCOM Limited, Royston, Hertfordshire SG8 6EE (GB)
(74) Representative: Haley, Stephen

(56) References cited:
- WO-A-01/03292
- WO-A-01/10013
- US-A- 6 008 698

## Description

This invention relates to the control of a power amplifier for use in mobile telecommunication systems such as mobile telephones.

The need to control the power amplifiers associated with the transmitting antennas in such systems is well known, and numerous different circuits for controlling such power amplifiers have been proposed previously. For example, numerous different types of control circuitry have been proposed for controlling power transmitter used in the GSM mobile telephony standard, and one such circuit is described below that has particular benefits when employed in a GSM system for data in the GMSK format that is well known within that system.

However, in recent times there has been a proposal to use a different format in the GSM system, that known as EDGE (enhanced data GSM environment). This format, which is described in the publications, GSM/EDGE: device characterisation for RF power amplifier. Jean Christophe Nanan. Motorola Toulouse. Microwave engineering Europe March 2000, Understanding Offset 8-PSK modulation for GSM EDGE. Ashkan Mashhour, Nokia Telecommations, Camberley, UK. Microwave Journal. October 1999, and GSM 3GPP TS 05.05 v 8.8.0 (2001-01), has certain advantages over the GMSK format in that it enables a higher data transmission rate and in that it makes more efficient use of the spectrum available for GSM transmissions. However, signals produced in accordance with this format have a number of characteristics which differ from those produced in accordance with the GMSK format. One characteristic is that of variable amplitude envelope. GMSK signals have a constant amplitude envelope which results in a straight- forward control concept when monitoring the output of a transmitter power amplifier for such signals, as is described below. However, EDGE signals have a variable envelope that makes such an approach to power amplifier control unacceptable and very likely to introduce large errors and discrepancies into the signal that which will largely reduce transmission accuracy. Another prior art system can be found disclosed in WO01/03292A.

Accordingly, the present invention seeks to provide control circuitry for use with a power amplifier for data signals with non-constant amplitude envelope that overcomes the problems associated with current known power amplifier circuitry.

According to the present invention there is provided a circuit for controlling the gain of a power amplifier for a transmitter, the circuit comprises:
means for monitoring the output of the power amplifier;
means for detecting the amplitude envelopes of the two monitored signals to produce envelope detected signals for each;
a comparator for comparing the envelopes of the signals; and
means for varying the gain of the power amplifier with a special gain control input,
the circuit being characterised in that:
   the means for monitoring the output of the power amplifier comprises an attenuator and a variable gain amplifier, the variable gain amplifier having its gain controlled by the output of a ramp digital-to-analogue converter.

Preferably, the circuit further comprises a power amplifier.

Preferably, the circuit further comprising an antenna.

Preferably, the circuit further comprises a transmitter circuit for producing an input to the power amplifier in accordance with the EDGE format.

The means for detecting the envelope may comprise diodes associated with the input and output signals of the power amplifier.

Preferably, the ramp digital-to-analogue converter provides a reference to the comparator.

With the present invention, signals coming from the output and input of the power amplifier will be detected by the log amplifiers and the first comparator will compute a voltage difference representing the difference in dB between the two signal levels, so that this difference can be interpreted as the RF gain of the power amplifier. When the EDGE data format is used, the signals produced by the log amplifiers will vary in amplitude reflecting the non-constant envelope nature of the EDGE signals. However, as the first comparator computes the difference in dB between the signal levels, the non-constant envelope will be removed from the difference computation. So, even signals with variable envelope, such as signals in accordance with the EDGE format, can be monitored to provide variable gain control of the power amplifier.

Examples of the present invention will now be described with reference to the accompanying drawings, in which:
Figure 1 is a schematic circuit diagram of a prior art amplifier control circuit;
Figure 2 is a schematic circuit diagram of a first example of the present invention; and
Figure 3 is a schematic circuit diagram of a comparative example.

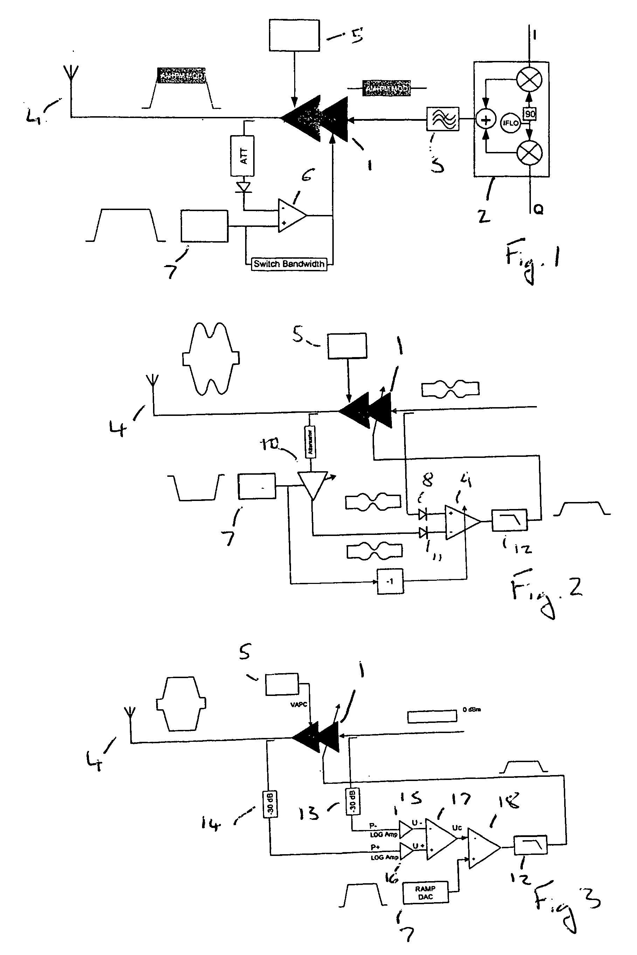

Referring to Figure 1, a known automatic power control (APC) circuit for a power amplifier 1 is shown. Also shown in Figure 1 is the associated circuitry for use with a power amplifier 1 in a mobile telecommunications device such as a mobile telephone.

In this circuit a signal to be transmitted is generated by a transmitter circuitry 2 from I and Q signals. The signal to be transmitted is then passed through a high frequency range cut-off band pass filter 3 to the power amplifier 1. The signal to be transmitted is then amplified by the power amplifier 1 and forwarded to an antenna 4 for transmission. In the prior art the output level of the power amplifier 1 is attenuated, detected and compared with the output of a fixed digital-to-analogue converter 5. The resulting error is used to adjust the desired transmission level in accordance with the reference provided by the digital-to analog converter. Such an APC circuit controls the power ramping of the power amplifier and ensures that temperature and supply voltage variations do not affect the output level of the power amplifier 1 during the active part of the burst signal.

This arrangement works well for a signal with a constant envelope, such as a GMSK format signal, but for a signal in which the amplitude envelope varies (such as an EDGE signal) it tends to reduce the dynamic of the envelope, affecting the output signal. This is because the control band-width must be designed for ramping of the power from the output of the ramp DAC 7. In practice this means that the output level needs to track the ramping shape over less than 20 ms, so the loop has a bandwidth of the order of 100 Khz. A control loop with this bandwidth will also provide, however, undesired compensation for amplitude envelope variations in an EDGE format signal, cutting out certain frequency components therefrom and reducing the signal's dynamic range.

Figure 2 is a schematic circuit diagram of a first example of an APC circuit according to the present invention. Components that correspond to those in figure 1 are numbered identically. In this circuit the input to the power amplifier 1 is a signal accordance with the EDGE format. This input signal is monitored and fed through a first envelope detecting diode 8 so that it can be provided to a comparator 9. The output of the power amplifier 1 is also monitored, attenuated, and then fed through a variable gain amplifier 10, the output of the variable gain amplifier 10 is then fed through a second envelope-detecting diode 11 and fed to the second input of the comparator 9. The gain of the variable gain amplifier 10 is controlled by the output of a ramp digital-to-analogue converter 7. Therefore the ramping signal from the ramp DAC 7 fixes the output level of the power amplifier as the envelope-detected signals must always remain the same. The output of the comparator 9 is then fed through an integrator 12 and the output used to control the gain of the power amplifier 1.

In this circuit the effect of amplitude envelope variation in the EDGE format signals is removed from the control loop. The error signal computed by the comparator will only reflect the gain variations due to supply voltage or temperature changes. This error signal is filtered by a low pass integrator 12 that fixes the control loop bandwidth to a an optimal value that guarantees stability over the required output power range, reduces the wideband noise level in the loop and follows the ramping signal with a reasonable accuracy.

Figure 3 shows an example that may be used in certain circumstances because of limitations in the circuitry of figure 2. For example, the circuitry of figure 2 may need in many circumstances additional gain compensation after the comparator in order to stabilise the loop bandwidth at the optimal value during power ramping. Also, in the circuit of figure 2 the feedback path must be very linear over the whole dynamic range of the signal that is input to the power amplifier 1, and in the case of an edge format signal this means from -13.4dBm to +32.4dBm. Also the amplitude detectors must be very linear over at least the EDGE dynamic range of 16.8 dB. Furthermore, in the circuit of figure 2 there is a need to control carefully any wide band noise generated in the feedback path.

The circuit of figure 3, in which components which correspond to those of the previous figures are numbered identically, employs a comparison of signal power to overcome the limitations of the circuit of figure 2. In this case, the input and output signals from the power amplifier 1 are monitored and attenuated by attenuators 13, 14 before being fed to log amplifiers 15, 16. The outputs of the log amplifiers 15,16 are then fed to comparison circuitry which comprises a first comparator 17, which provides an output signal which is indicative of the difference between the outputs of the log amplifiers 15,16. The comparator circuitry 17 then comprises a further comparator 18 which compares the output of the first comparator 17 with that of a ramp DAC 7. Again, the output of the comparator circuitry 17, 18 is fed through a low pass filter 12 before being used to control the gain of the power amplifier 1.

As already explained, by comparing the power of the input and output signals for the power amplifier 1, the envelope of the input signal and the output signal are removed from the comparison. With this circuitry the feedback loop that it provides is effectively providing a small-signal gain which varies as the derivative of a logarithmic function, so that the loop has maximum gain at low power levels and minimum gain at high power levels. These small signal gain variations are compensated by the nonlinear nature of the gain control characteristics of the power amplifier. At low power, the power amplifier has a small small-signal-gain and at high power level, the power amplifier has a high small-signal gain. So that, in the end, the feedback loop bandwidth remains constant and stable over the power ramping range.

## Claims

1. A circuit for controlling the gain of a power amplifier (1) for a transmitter, the circuit comprising:
means for monitoring the input to the power amplifier;
means for monitoring the output of the power amplifier;
means for detecting the amplitude envelopes of the two monitored signals to produce envelope detected signals for each;
a comparator (9) for comparing the envelopes of the signals; and
means for varying the gain of the power amplifier with a special gain control input,
the circuit being **characterised in that**:
the means for monitoring the output of the power amplifier comprises an attenuator and a variable gain amplifier (10) connected in series, the variable gain amplifier having its gain controlled by the output of a ramp digital-to-analogue converter (7).

2. A circuit according to claim 1 further comprising a power amplifier (1).

3. A circuit according to claim 1 or claim 2, further comprising an antenna (4).

4. A circuit according to any of claims 1 to 3 further comprising a transmitter circuit for producing an input to the power amplifier in accordance with the EDGE format.

5. A circuit according to any preceding claim, where the means for detecting the envelope comprises diodes (8,11) associated with the input and output signals of the power amplifier (1).

6. A circuit according to any one of the preceding claims, wherein the ramp digital-to-analogue (7) converter provides a reference to the comparator (9).

## Patentansprüche

1. Schaltung zum Steuern der Verstärkung eines Leistungsverstärkers (1) für einen Transmitter, wobei die Schaltung folgende Merkmale aufweist:
eine Einrichtung zum Überwachen des Eingangs in den Leistungsverstärker;
eine Einrichtung zum Überwachen des Ausgangs des Leistungsverstärkers;
eine Einrichtung zum Erfassen der Amplituden-Einhüllenden der beiden überwachten Signale, um für sie jeweils hüllkurvendetektierte Signale zu erzeugen;
einen Komparator (9) zum Vergleichen der Einhüllenden der Signale; und
eine Einrichtung zum Variieren der Verstärkung des Leistungsverstärkers mit einer speziellen Verstärkungssteuerungseingabe,
wobei die Schaltung **dadurch gekennzeichnet ist, dass**:
die Einrichtung zum Überwachen des Ausgangs des Leistungsverstärkers ein Dämpfungsglied und einen variablen Verstärkungsverstärker (10) aufweist, der in Reihe geschaltet ist, wobei der variable Leistungsverstärker seine Verstärkung durch die Ausgabe eines Rampen-Digital-Analog-Wandlers (7) steuern lässt.

2. Schaltung nach Anspruch 1, die ferner einen Leistungsverstärker (1) aufweist.

3. Schaltung nach Anspruch 1 oder 2, die ferner eine Antenne (4) aufweist.

4. Schaltung nach einem der Ansprüche 1 bis 3, die ferner eine Transmitterschaltung zum Erzeugen einer Eingabe in den Leistungsverstärker gemäß EDGE-Format aufweist.

5. Schaltung nach den vorhergehenden Ansprüchen, wobei die Einrichtung zum Erfassen der Hüllkurve Dioden (8, 11) aufweist, die den Eingangs- und Ausgangssignalen des Leistungsverstärkers (1) zugeordnet sind.

6. Schaltung nach einem der vorhergehenden Ansprüche, wobei der Rampen-Digital-Analog-Wandler (7) eine Referenz zum Komparator (9) bereitstellt.

## Revendications

1. Circuit pour commander le gain d'un amplificateur de puissance (1) pour un émetteur, le circuit comprenant :
un moyen pour surveiller l'entrée de l'amplificateur de puissance ;
un moyen pour surveiller la sortie de l'amplificateur de puissance ;
un moyen pour détecter les enveloppes d'amplitude des deux signaux surveillés pour produire des signaux détectés d'enveloppes pour chacun ;
un comparateur (9) pour comparer les enveloppes des signaux ; et
un moyen pour modifier le gain de l'amplificateur de puissance avec une entrée de commande de gain spéciale,
le circuit étant **caractérisé en ce que** :
le moyen pour surveiller la sortie de l'amplificateur de puissance comprend un atténuateur et un amplificateur à gain variable (10) reliés en série, l'amplificateur à gain variable ayant son gain commandé par la sortie d'un convertisseur numérique-analogique à rampe (7).

2. Circuit selon la revendication 1, comprenant en outre un amplificateur de puissance (1).

3. Circuit selon la revendication 1 ou la revendication 2, comprenant en outre une antenne (4).

4. Circuit selon l'une quelconque des revendications 1 à 3, comprenant en outre un circuit de transmission pour produire une entrée de l'amplificateur de puissance selon le format EDGE.

5. Circuit selon l'une quelconque des revendications précédentes, où le moyen pour détecter l'enveloppe comprend des diodes (8, 11) associées aux signaux d'entrée et de sortie de l'amplificateur de puissance (1).

6. Circuit selon l'une quelconque des revendications précédentes, dans lequel le convertisseur numérique-analogique à rampe (7) fournit une référence au comparateur (9).
